# EUROPÄISCHE PATENTSCHRIFT

(11) **EP 0 554 521 B1**
(45) Veröffentlichungstag und Bekanntmachung des Hinweises auf die Patenterteilung: **26.07.1995**
(21) Anmeldenummer: 92119072.4
(22) Anmeldetag: 06.11.1992
(51) Int. Cl.: C23C 14/50, C23C 16/46, C23C 16/56, C23C 14/24, C23C 14/54, C23C 14/56, C23C 14/58

(54) **Vorrichtung für die Wärmebehandlung und den Transport von Substraten**
Apparatus for heat treating and transporting substrates
Dispositif pour le traitement thermique et le transport de substrats

(30) Priorität: 04.02.1992 DE 4203080
(43) Veröffentlichungstag der Anmeldung: 11.08.1993
(73) Patentinhaber: LEYBOLD AKTIENGESELLSCHAFT, D-63450 Hanau (DE)
(72) Erfinder: Latz, Rudolf, Dr., W-6074 Rodgau 2 (DE)

(56) Entgegenhaltungen:
- EP-A- 0 254 145
- EP-A- 0 476 219
- PATENT ABSTRACTS OF JAPAN, unexamined applications, E Sektion, Band 9, Nr. 19, 25. JUnner 1985 THE PATENT OFFICE JAPANESE GOVERNMENT Seite 81 E 292; & JP-A-59-167 013 (KOGYO GIJUTSUIN)

## Beschreibung

Die Erfindung betrifft eine Vorrichtung für die Wärmebehandlung und den Transport von Substraten bei Vakuumbeschichtungsanlagen mit mehreren Stationen, mit Substrathaltern mit etwa plattenförmiger, flacher, parallelepipeder Konfiguration, die in lotrechter Stellung entlang eines vorgegebenen Transportweges durch die Stationen bewegbar sind, und mit Paaren von Wälzkörpern, Gleitsteinen oder Rollen, die im Zusammenwirken mit Schienen die Substrathalter halten und führen und die jeweils im Bereich ihres Fußteils unterhalb der an den Substrathaltern befestigbaren Substraten vorgesehen sind, wobei die Substrathalter rahmenförmig ausgebildete, in parallelen Ebenen angeordnete Seitenteile aufweisen, in deren fensterförmigen Öffnungen die Substrate einlegbar sind. Eine Transporteinrichtung der genannten Gattung ist durch die DE 41 25 334 bekannt.

Die zum Einsatz kommenden Substrathalter sind entweder Platten mit entsprechend den Substraten geformten Ausschnitten oder Rahmen mit Streben, an denen die Substrate befestigt werden. Im allgemeinen dient ein Substrathalter zur Aufnahme einer Vielzahl von Substraten.

Durch die US 4,042,128 ist eine Transporteinrichtung der eingangs beschriebenen Gattung bekannt, bei der plattenförmige Substrathalter bei vertikaler Lage ihrer Hauptebene an ihren oberen und unteren Längskanten zwischen Rollen geführt werden, die um senkrechte Achsen drehbar sind. An ihren Unterkanten liegen die Substrathalter zusätzlich auf Stützrollen mit horizontaler Drehachse auf. Die unteren Führungsrollen sind jedoch nicht im Stande, die Substrathalter allein in genau vertikaler Stellung zu halten und zu transportieren, so daß eine stabile Positionierung nur unter Zuhilfenahme der oberen Führungsrollen möglich ist.

Bekannt ist auch eine Transporteinrichtung für Vakuumbeschichtungsanlagen (EP 0 254 145) mit mehreren Stationen und mit Rollensystemen für die Führung und den Vorschub von im wesentlichen zweidimensionalen Substrathaltern in senkrechter Stellung, entlang eines vorgegebenen Transportweges durch die Stationen, wobei im Bereich der Unterkante der Substrathalter paarweise Führungsrollen angeordnet sind, die den Substrathalter zwischen sich aufnehmen und die um senkrechte Achsen drehbar sind, wobei die Substrathalter ausschließlich im Bereich ihrer Unterkante durch die Rollensysteme geführt sind und die Führungsrollen mit Laufflächen versehen sind, die auf mindestens einer Führungsrolle eines Rollenpaares jeweils am unteren und am oberen Ende angeordnet sind, wobei die jeweils andere Führungsrolle des gleichen Rollenpaares mindestens eine Lauffläche aufweist und wobei die mindestens drei Laufflächen eines Rollenpaares in bezug auf den Substrathalter eine kippsichere Einspannung bilden.

Weiterhin ist es bekannt (DE 31 07 914), die zu beschichtenden Substrate in einer besonderen Schleusenkammer mit einer Heizeinrichtung thermisch vorzubehandeln. Man hat auch bereits vorgeschlagen, den Substrathalter bei einer Transporteinrichtung für eine Vakuumbeschichtungsanlage mit einem Fußteil auszustatten, das auf ortsfesten Schienen gleitet (EP 0 346 815).

Schließlich wurde auch bereits eine Vorrichtung vorgeschlagen (DE 40 29 905, korrespondiert zu EP-A-0 476 219 mit der Priorität vom 21.09.90 und welche vor dem Anmeldetag, aber nach dem Prioritätsdatum der vorliegenden Anmeldung veröffentlicht wurde.) mit mehreren Stationen, mit Substrathaltern mit etwa plattenförmiger, flacher, parallelepipeder Konfiguration, die in lotrechter Stellung entlang eines vorgegebenen Transportweges durch die Stationen bewegbar sind und die mit Schienen zusammenwirken, die jeweils im Bereich ihres Fußteils unterhalb der an den Substrathaltern befestigbaren Substraten vorgesehen sind, wobei das Fußteil des Substrathalters mit einem Paar parallel und im Abstand zueinander verlaufender, in einer lotrechten Ebene angeordneter Schienen vorsehen ist, deren einander zugekehrte Schmalseiten Längsnuten aufweisen, die mit Rollen oder Gleitsteinen korrespondieren, die ortsfest am Bodenteil der Vorrichtung gelagert sind und die jeweils in Reihen - entsprechend dem Verlauf der Nuten - in übereinander liegenden, vertikalen Ebenen im Abstand zueinander vorgesehen sind, wobei der Substrathalter eine sich von oben her bis in den Bereich seines Fußteils erstreckende, parallel zu den Schienen verlaufende, schachtförmige Aussparung aufweist, in die beim Durchlauf durch die Station ein oberhalb des Substrathalters am oberen Wandteil angeordneter, flacher, sich lotrecht nach unten zu erstreckender Heizkörper, der als Widerstandsheizkörper ausgebildet ist, hineinragt.

In Weiterausbildung der Erfindung bezweckt die vorliegende Erfindung, die Vorrichtung so zu verbessern, daß bei Substraten, die aus einem elektrisch isolierenden Werkstoff bestehen und auf die eine dünne Schicht aus einem elektrisch leitenden Material aufgebracht ist, diese Schicht zum Zwecke des Temperns besonders rasch aufgeheizt werden kann, und zwar ohne daß sich das Substrat selbst dabei merklich erwärmt und ohne daß ein gegenüber elektromagnetischen Feldern besonders empfindliches Substrat Schaden nimmt.

Diese Aufgabe wird erfindungsgemäß dadurch gelöst, daß an ortsfesten Halterungen Schleifkontakte vorgesehen sind, deren federnde Enden jeweils an der elektrisch leitenden Schicht während der Bewegung durch die Station an der Schicht anliegen, wobei über diese Schleifkontakte und die Schicht kurzzeitig ein Stromkreis schließbar ist, der eine Aufheizung der Schicht und damit ein Tempern des Schichtwerkstoffs bewirkt. In einer bevorzugten Ausführungsform der Vorrichtung ist ein Stromkreis, über die Schleifkontakte und die elektrisch leitende Schicht, in Pulsen schließbar.

Die Erfindung läßt die verschiedensten Ausführungsmöglichkeiten zu; eine davon ist in der anhängenden Zeichnung schematisch näher dargestellt, die den Schnitt quer durch eine Vorrichtung zeigt.

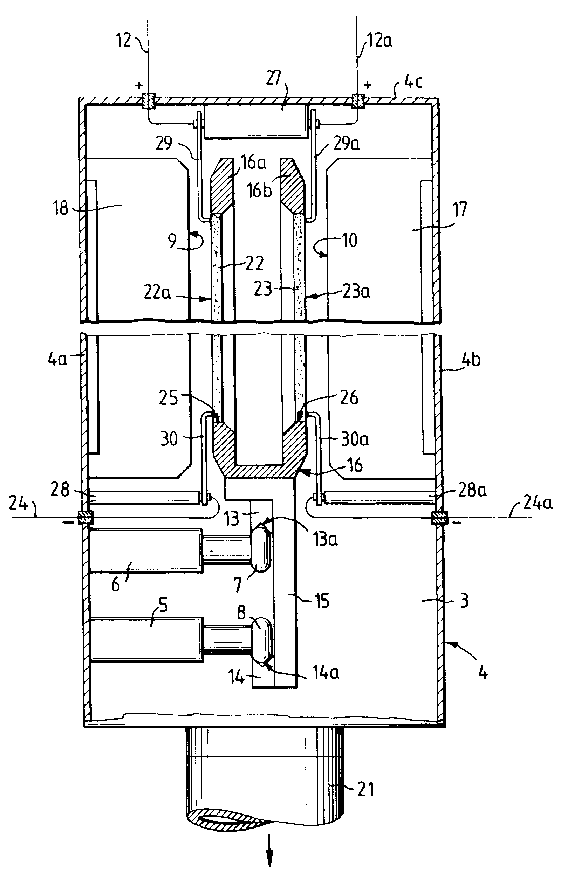

Wie die Zeichnung zeigt, besteht die Vorrichtung aus den in der Beschichtungskammer 3 an der einen Seitenwand 4a des Gehäuses 4 an sich horizontal erstreckenden Armen 5, 6 drehbar gelagerten Rollen 7, 8, den beiden an den Seitenwänden 4a, 4b fest angeordneten Kathoden 9, 10, dem am oberen Wandteil 4c bzw. am Isolator 27 gehaltenen Schleifkontakten 29, 29a mit den zugehörigen Zuleitungen 12, 12a, dem mit Schienen 13, 14 versehene Fußteil 15 des im Querschnitt U-förmig ausgeformten Substrathalters 16, den beiden rahmenförmigen, die Substrate 22, 23 haltenden Seitenteilen 16a, 16b des Substrathalters 16, den beiden Isolatoren bzw. Halterungen 28, 28a, mit den an ihnen befestigten Schleifkontakten 30, 30a, den Kathodenblenden 17, 18 und schließlich dem Absaugstutzen 21 einer nicht näher dargestellten Turbomolekularpumpe.

Während des Betriebs der in der Zeichnung schematisch dargestellten Beschichtungsstation werden die Substrate 22, 23 in einer Richtung lotrecht zur Schnittebene bewegt, bis sie den Kathoden 9, 10 gegenüberstehen, wie dies aus der Zeichnung ersichtlich ist.

Nach der Beschichtung der Außenflächen 22a, 23a der Substrate 22, 23 werden diese in der gleichen Richtung (lotrecht zur Zeichenebene) bis zur nächsten Bearbeitungsstation weiterbewegt. Die scheibenförmigen Substrate 22, 23 werden von den sie rahmenförmig umschließenden Seitenteilen 16a, 16b des Substrathalters 16 gehalten, der seinerseits fest mit dem Fußteil 15 verbunden oder einstückig mit diesem ausgebildet ist. Das Fußteil 15 ist mit einem Paar von Schienen 13, 14 verschraubt oder verschweißt, die ihrerseits Längsnuten 13a, 14a aufweisen, in denen Rollen 7 bzw. 8 laufen, die in zwei Reihen in Abständen hintereinanderliegend drehbar auf Armen 5 bzw. 6 gelagert sind. Der Abstand, den die Reihen von Rollen 5 bzw. 6 zueinander aufweisen, ist so gewählt, daß das Fußteil 15 auf diesen kippsicher gehalten und geführt ist.

Um sicherzustellen, daß die Substratschichten 22a, 23a die für den Temperprozeß erforderliche Temperatur aufweisen, sind am oberen Wandteil 4c des Gehäuses 4 an einem Isolator bzw. Halterung 27 Schleifkontakte 12, 12a so befestigt, daß ihre freien Enden federnd an der Schicht 22a bzw. 23a anliegen, wenn sich die Substrate 22, 23 mit ihrer Substrathalterung 16 im Bereich der Station befinden. Gleichzeitig gelangen auch die Schleifkontakte 30, 30a in Kontakt mit der Schicht 22a bzw. 23a (Indium-Zinn-Oxid-Schicht), so daß über die Schicht 22a, 23a jeweils ein Stromdurchgang möglich ist, der eine Aufheizung der Schichten bewirkt.

Ein wesentlicher Vorteil der beschriebenen Vorrichtung besteht insbesondere darin, daß die einzusetzende Wärme nur in dem Augenblick erzeugt wird, wenn sich das Substrat unmittelbar im Bereich der Schleifkontakte 12, 12a bzw. 30, 30a befindet, so daß die Anlage selbst sich nicht weiter aufheizt und die Wärme - örtlich begrenzt - besonders gut kontrolliert werden kann (z. B. darf ein Substrat aus "Plexiglas" nur einer maximalen Temperatur von 100 °C ausgesetzt werden). Beim Tempern ist das Substrat 22, 23 selbst keinen elektromagnetischen Feldern ausgesetzt. Der zum Aufheizen der Schicht (z. B. einer ITO-Schicht) jeweils erforderliche Strom fließt zweckmäßigerweise "gepulst", d. h. nur kurzzeitig und portionsweise (im Bereich von wenigen Sekunden). Es ist klar, daß sowohl Wechselstrom- als auch Gleichstrompulse benutzt werden können. Auch ein Heizstrom hoher Frequenz (z.B. im kHz-Bereich) hat sich als zweckmäßig erwiesen. Das Tempern kann sowohl unter Vakuum als auch in einer Gasatmosphäre unter bestimmtem Druck erfolgen.

### Bezugszeichenliste

- 3: Beschichtungskammer
- 4: Gehäuse
- 4a: Seitenwand des Gehäuses
- 4b: Seitenwand des Gehäuses
- 4c: oberes Wandteil des Gehäuses
- 5: Arm
- 6: Arm
- 7: Rolle
- 8: Rolle
- 9: Kathode
- 10: Kathode
- 12, 12a: elektrische Zuleitung
- 13: Schiene
- 13a: Längsnut
- 14: Schiene
- 14a: Längsnut
- 15: Fußteil
- 16: Substrathalter
- 16a: Seitenteil des Substrathalters
- 16b: Seitenteil des Substrathalters
- 17: Kathodenblende
- 18: Kathodenblende
- 21: Absaugstutzen
- 22: Substrat
- 22a: elektrisch leitende Schicht des Substrats
- 23: Substrat
- 23a: elektrisch leitende Schicht des Substrats
- 24, 24a: elektrische Zuleitung
- 25: fensterförmige Ausnehmung
- 26: fensterförmige Ausnehmung
- 27: Halterung, Isolator
- 28, 28a: Halterung, Isolator
- 29, 29a: Schleifkontakt
- 30, 30a: Schleifkontakt

## Patentansprüche

1. Vorrichtung für den Transport von Substraten (22, 23) bei Vakuumbeschichtungsanlagen mit mehreren Stationen, mit Substrathaltern (16) mit etwa plattenförmiger, flacher, parallelepipeder Konfiguration, die in lotrechter Stellung entlang eines vorgegebenen Transportweges durch die Stationen bewegbar sind und die mit Schienen (13, 14) zusammenwirken, die jeweils im Bereich ihres Fußteils (15) unterhalb der an den Substrathaltern (16) befestigbaren Substraten (22, 23) vorgesehen sind, wobei der Substrathalter (16) rahmenförmig ausgeformte, in parallelen Ebenen angeordnete Seitenteile (16a, 16b) aufweist, in deren fensterartigen Öffnungen (25, 26) die Substrate (22, 23) einlegbar sind, **dadurch gekennzeichnet,** daß an ortsfesten Halterungen (27, 28) Schleifkontakte (29, 29a bzw. 30, 30a) vorgesehen sind, deren federnde Enden jeweils an der elektrisch leitenden, auf das Substrat (22, 23) aufgebrachten Schicht (22a, 23a) bei der Bewegung durch die Station anliegen, wobei über diese Schleifkontakte (29, 29a bzw. 30, 30a) und die Schicht (22a, 23a) kurzzeitig ein Stromkreis schließbar ist, der eine Aufheizung der Schicht (22a bzw. 23a) und damit ein Tempern des Schichtwerkstoffs bewirkt.

2. Vorrichtung nach Anspruch 1 dadurch gekennzeichnet, daß über die Schleifkontakte (29, 29a bzw. 30, 30a) und die Schicht (22a, 23a) ein Stromkreis in Pulsen schließbar ist.

## Claims

1. Apparatus for transporting substrates (22, 23) in vacuum coating plants with a plurality of bays, comprising substrate mounts (16) with a flat, approximately tray-shaped, parallelipipedal configuration, which are movable through the bays in a vertical position along a predetermined conveying path and cooperate with rails (13, 14), which are provided in the respective region of their base part (15) below the substrates (22, 23) which are fixable to the substrate mounts (16), wherein the substrate mount (16) has frame-like side members (16a, 16b) disposed in parallel planes and in whose window-like apertures (25, 26) the substrates (22, 23) are insertable, characterised in that on non-displaceable mounts (27, 28) sliding contacts (29, 29a and 30, 30a respectively) are provided, whose resilient ends respectively abut the electrically conductive coating (22a, 23a) applied to the substrate (22, 23) while moving through the bay, these sliding contacts (29, 29a and 30, 30a respectively) and the coating (22a, 23a) briefly completing an electric circuit, which effects heating of the coating (22a and 23a respectively) and thereby tempers the coating material.

2. Apparatus according to claim 1, characterised in that an electric circuit can be completed in a pulsed manner via the sliding contacts (29, 29a and 30, 30a respectively) and the coating (22a, 23a).

## Revendications

1. Dispositif pour le transport de substrats (22, 23) dans des installations de revêtement sous vide présentant plusieurs stations, comportant des porte-substrats (16) ayant une configuration approximativement en forme de plaque, plate, parallélépipédique, qui peuvent être déplacés en position verticale le long d'un trajet de transport prédéterminé à travers les stations, et qui coopèrent avec des rails (13, 14) qui sont prévus respectivement dans la région de leur partie de pied (15), au-dessous des substrats (22, 23) susceptibles d'être fixés sur les porte-substrats (16), le porte-substrats (16) présentant des parties latérales (16a, 16b) réalisées en forme de cadre et agencées dans des plans parallèles, lesquelles présentent des ouvertures en forme de fenêtre (25, 26) dans lesquelles on peut placer les substrats, caractérisé en ce qu'il est prévu sur des fixations stationnaires (27, 28) des contacts frotteurs (29, 29a ou 30, 30a), dont les extrémités élastiques s'appuient lors du mouvement à travers la station respectivement contre la couche électriquement conductrice (22a, 23a) déposée sur le substrat (22, 23); dans lequel on peut connecter brièvement via des contacts frotteurs (29, 29a ou 30, 30a) et la couche (22a, 23a) un circuit électrique qui provoque un réchauffement de la couche (22a ou 23a) et ainsi un recuit de la matière de la couche.

2. Dispositif selon la revendication 1, caractérisé en ce que l'on peut connecter un circuit électrique par impulsions via les contacts frotteurs (29, 29a ou 30, 30a) et la couche (22a, 23a).
